# EUROPÄISCHE PATENTSCHRIFT

(11) **EP 1 811 826 B1**
(45) Veröffentlichungstag und Bekanntmachung des Hinweises auf die Patenterteilung: **05.03.2008**
(21) Anmeldenummer: 06020340.3
(22) Anmeldetag: 28.09.2006
(51) Int. Cl.: H05K 7/14

(54) **Gehäuse eines elektronischen Gerätes, ausgebildet für den Einsatz in einem Fahrzeug**
Caseing for an electronic apparatus for a vehicule
Boîtier d'un dispositif électronique d'un véhicule

(30) Priorität: 24.01.2006 DE 10603234
(43) Veröffentlichungstag der Anmeldung: 25.07.2007
(73) Patentinhaber: Hirschmann Car Communication GmbH, 72654 Neckartenzlingen (DE)
(72) Erfinder: Silva, David, 72622 Nürtingen (DE)
(74) Vertreter: Thul, Hermann

(56) Entgegenhaltungen:
- EP-A- 0 792 003
- EP-A- 1 592 291
- EP-A1- 0 739 783
- CH-A5- 667 959
- US-A- 5 680 296
- US-A1- 2004 007 379
- ANONYMOUS: "Snap and turn retainer for book package cover and card control" RESEARCH DISCLOSURE, MASON PUBLICATIONS, HAMPSHIRE, GB, Bd. 345, Nr. 90, Januar 1993 (1993-01), XP007118610 ISSN: 0374-4353

## Beschreibung

Die Erfindung betrifft ein Gehäuse eines elektronischen Gerätes, ausgebildet für den Einsatz in einem Fahrzeug, gemäß den Merkmalen des Oberbegriffes des Patentanspruches 1, wie aus EP-A- 0 739 738 bekannt ist.

Gehäuse für elektronische Geräte, wobei in dem Gehäuse zumindest zwei Leiterplatten mit Bauteilen zur Realisierung der Funktion des Gerätes untergebracht sind, sind grundsätzlich bekannt. Wenn solche Gehäuse für elektronische Geräte für die Anwendung in Fahrzeugen ausgebildet sind, unterliegen sie erhöhten Anforderungen hinsichtlich der Festigkeit, der Temperaturschwankungen und der Beständigkeit im Hinblick auf Vibrationen. Solche aus Kunststoff oder Metall bestehenden Gehäuse weisen im Regelfall ein oder mehrere Teile (Gehäuseschale und Deckel oder Ober- und Unterteil) auf, in welche eine mit Bauteilen zur Realisierung der Funktionen des Gerätes vorbereitete einzige Leiterplatte eingesetzt und mit mehreren Schrauben an einem Teil des Gehäuses verschraubt wird. Solche Geräte wie z.B. Antennenverstärker, TV-Tuner oder dergleichen genügen dann den Anforderungen hinsichtlich ihrer Robustheit für die Anwendung in Fahrzeugen, benötigen aber viel Bauraum (in diesem Fall Fläche), da auf dieser einzigen Leiterplatte alle Bauteile zur Realisierung der Funktion des Gerätes untergebracht sind.

Um den Flächenbedarf zu verringern, ist es schon bekannt geworden, eine Leiterplatte (Motherboard) einzusetzen, auf der verschiedene länglich ausgebildete Steckverbinder vorgesehen sind, um senkrecht zu dieser Leiterplatte weitere Leiterplatten aufzunehmen. Diese Anordnung reduziert zwar den Flächenbedarf, allerdings ist die Erstreckung in der Höhe relativ groß, so dass auch diese Anordnung hinsichtlich des Bauraumes von Nachteil ist. Ein weiterer Nachteil ist darin zu sehen, dass mehrere parallel zueinander und senkrecht zu dem Motherboard angeordnete Leiterplatten einen hohen Aufwand an Abschirmmaßnahmen bedürfen und auch die Kühlung auf Grund der gegenseitigen Wärmeentwicklung problematisch ist. Der Erfindung liegt daher die Aufgabe zu Grunde, ein Gehäuse eines elektronischen Gerätes, ausgebildet für den Einsatz in einem Fahrzeug, wobei in dem Gehäuse zumindest zwei Leiterplatten mit Bauteilen zur Realisierung der Funktion des Gerätes untergebracht sind, bereitzustellen, das einerseits einen geringeren Raumbedarf aufweist, das andererseits-aber auch einfach herzustellen und bei dem die Leiterplatten leicht zu montieren sind.

Diese Aufgabe ist durch die Merkmale des Patentsanspruches 1 gelöst.

Erfindungsgemäß ist vorgesehen, dass die Leiterplatten planparallel und beabstandet in dem Gehäuse angeordnet sind, wobei seitlich am Rand der Leiterplatten Distanzhalter rastend an den Leiterplatten befestigt sind. Die Anordnung von zumindest zwei oder mehr als zwei Leiterplatten planparallel (koplanar) und damit beabstandet zueinander hat den Vorteil, dass auf Grund dieser "Sandwichbauweise" die Höhe des Gehäuses klein gehalten werden kann, gleichzeitig aber die zur Verfügung stehende Fläche für das Gehäuse optimal ausgenutzt wird. Die Wärmeabfuhr, sofern vorhanden, kann ohne weiteres beispielsweise mit einem Lüfter oder dergleichen dadurch erfolgen, dass ein Luftstrom (oder andere Kühlmittel) durch den Raum zwischen den beiden Leiterplatten geführt wird. Gleiches gilt für Abschirmmaßnahmen, die besonders einfach gehalten werden können, da zum Beispiel ein aus Metall bestehendes Gehäuse oder flächige, zwischen den beiden Leiterplatten angeordnete Abschirmmittel für die Abschirmung dienen können. Dadurch entsteht ein flachbauendes Gehäuse, welches die zur Verfügung stehende Fläche optimal ausnutzt und damit dem vorhandenen Bauraum optimal angepasst werden kann. Denn bei dem Einsatz von solchen elektronischen Geräten in Fahrzeugen steht oftmals mehr Bauraum in der Fläche als in der Höhe zur Verfügung. Weiterhin ist hinsichtlich der Montagefreundlichkeit der Vorteil gegeben, dass seitlich am Rand der Leiterplatten Distanzhalter rastend an den Leiterplatten befestigbar sind. Diese Distanzhalter bewirken, dass die beiden Leiterplatten planparallel und damit beabstandet zueinander in dem Gehäuse angeordnet werden können. Auf Grund der rastenden Befestigung ist der Vorteil einer schnellen Montage gegeben, wobei vor allen Dingen die beiden Leiterplatten nach ihrer Herstellung und Bestückung mit den Bauteilen mittels der Distanzhalter beabstandet zu einem Paket vormontierbar sind, welches dann nur noch in das Gehäuse, gegebenenfalls unter Durchführung einer weiteren Verkabelung, eingesetzt werden muss. Die rastende Befestigung der Distanzhalter, vorzugsweise an gegenüber liegenden Seitenkanten der Leiterplatten,-wobei an jeder-Seitenkante der Leiterplatte ein oder mehrere Distanzhalter befestigbar sind, hat weiterhin den Vorteil, dass die Leiterplatten mittels der Distanzhalter in ihrer Sollposition in dem Gehäuse festgelegt werden. Damit genügt ein solches Gehäuse mit über Distanzhaltern eingesetzten Leiterplatten den Anforderungen in Fahrzeugen, insbesondere hinsichtlich der Beständigkeit in Bezug auf Temperaturschwankungen und Vibrationen. Dabei ist es denkbar, dass die Distanzhalter kraft- und/oder formschlüssig an dem Gehäuse, insbesondere dessen Seitenteilen, befestigt werden. So können die Distanzhalter mit ihrem Rückenteil beispielsweise an dem Gehäuse verklebt, verrastet, verschraubt oder verspannt werden. Eine Federlasche in jedem Distanzhalter, die sich an dem Gehäuse abstützt, hat den Vorteil, dass Vibrationen und auch Toleranzen ausgeglichen werden. Alternativ zur Ausgestaltung von Federlaschen zwecks Toleranz- und Vibrationsausgleich sind auch elastisch verformbare Mittel zwischen den Distanzhaltern und dem Gehäuse des elektronischen Gerätes denkbar.

In Weiterbildung der Erfindung ist der Distanzhalter als Stanzbiegeteil ausgebildet. Dies hat den Vorteil, dass solche Distanzhalter als Massenware schnell und kostengünstig hergestellt werden können, wobei auch das Ausgangsmaterial (ein flacher Blechstreifen) kostengünstig ist. Werden solche Distanzhalter aus Metall im Stanzbiegeverfahren hergestellt, haben sie darüber hinaus den Vorteil, dass sie mit elektrisch leitenden Bereichen am Rand der Leiterplatten zwecks Abschirmung verbunden werden können.

Weitere Ausgestaltungen der Erfindung sind in den Unteransprüchen angegeben, aus denen die entsprechenden Vorteile resultieren. Besonders vorteilhaft ist es, wenn der Distanzhalter an seinen beiden Enden einen Klemmbereich zur Aufnahme des seitlichen Randes der Leiterplatten aufweist. Denn neben der rastenden Befestigung der Leiterplatten an dem Distanzhalter bewirkt der Klemmbereich, dass zwecks Toleranz- und Spielausgleich und damit zur Verhinderung von Vibrationen die Leiterplatten über die Distanzhalter in einer genauen Lage in Bezug auf das Gehäuse festgelegt werden können.

Ausführungsbeispiele der Erfindung, auf die diese jedoch nicht beschränkt ist, sind im Folgenden beschrieben und anhand der Figuren erläutert.

Es zeigen:
- Figuren 1 und 2:: verschiedene Ansichten eines ersten Ausführungsbeispieles eines Distanzhalters,
- Figur 3:: ein zweites Ausführungsbeispiel eines Distanzhalters,
- Figur 4:: ein weiteres Ausführungsbeispiel eines Distanzhalters.

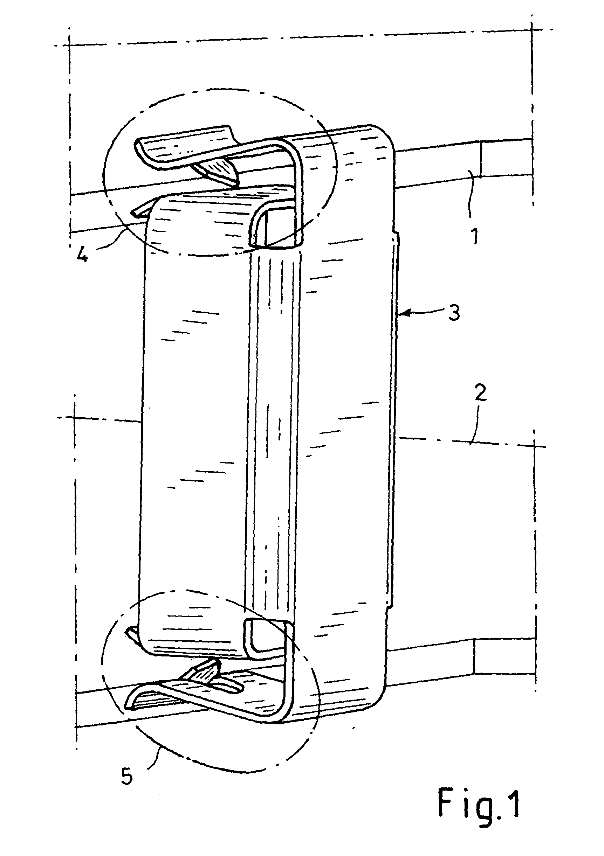

In Figur 1 ist, soweit im Einzelnen dargestellt, mit 1 und 2 jeweils eine Leiterplatte eines nicht näher dargestellten elektronischen Gerätes gezeigt. Zwecks Vereinfachung der Darstellung ist auch das ein- oder mehrteilige Gehäuse des elektronischen Gerätes, welches aus Kunststoff oder Metall (z.B. Druckguss) oder einer Kombination von beidem hergestellt werden kann, nicht dargestellt. Die beiden Leiterplatten 1, 2 werden in ihrem Randbereich über einen erfindungsgemäßen Distanzhalter 3 miteinander verbunden, der in seinen Endbereichen so geformt bzw. gestaltet ist, dass er durch einfaches Aufstecken auf den Rand der jeweiligen Leiterplatte 1, 2 rastend befestigbar ist. Beim Einsatz des elektronischen Gerätes in Fahrzeugen ist die rastende Verbindung erforderlich, um zu verhindern, dass sich die Leiterplatten 1, 2 auf Grund von Vibrationen von dem Distanzhalter 3 lösen.

In einer bevorzugten Ausführungsform weist der Distanzhalter in seinen Endbereichen, die bei diesem Ausführungsbeispiel als Klemmbereiche 4, 5 ausgebildet sind, noch zu beschreibende Rastmittel auf.

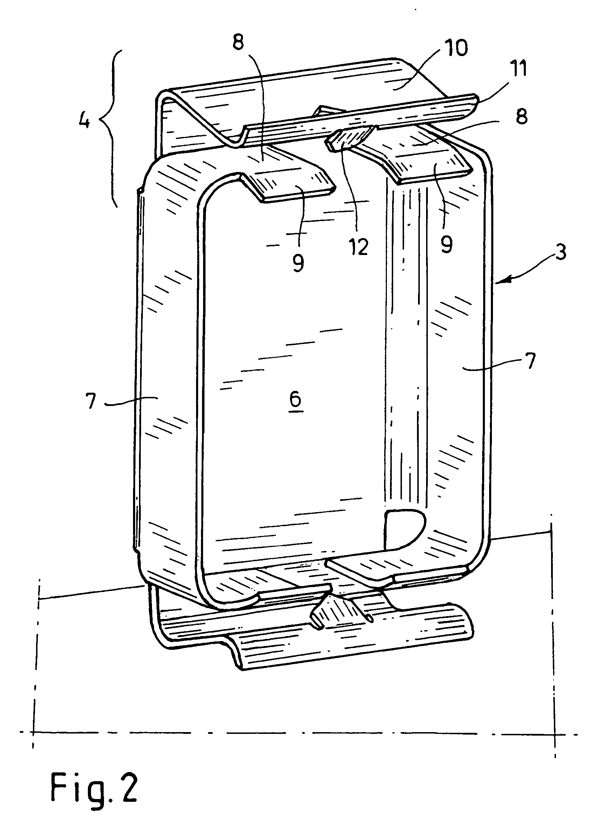

Figur 2 zeigt den Distanzhalter 3 gemäß Figur 1, allerdings in einer breiteren Ausführungsform, um die Auflageflächen und daraus resultierend die Haltekräfte für die Leiterplatten 1, 2 zu erhöhen. Der Distanzhalter 3 gemäß Figur 2 wird ebenfalls im Stanzbiegeverfahren hergestellt und erhält ein Rückenteil 6, von dem zu beiden Seiten Seitenteile 7 abgewinkelt sind. Am Ende der Seitenteile 7 sind im Klemmbereich 4, 5 untere Laschen abgewinkelt, die an ihrem Ende jeweils eine Abwinklung 9 aufweisen. Zur Realisierung der Klemmbereiche 4, 5 erstreckt sich, ausgehend von dem Rückenteil 6, abgewinkelt eine obere Lasche 10, die an ihrem Ende ebenfalls eine Abwinklung 11 tragen kann aber nicht muss. Die Abwinklungen 9, 11, haben den Vorteil, dass sie den Einsatz der Leiterplatte 1, 2 in den Klemmbereich 4, 5 erleichtern. Die Laschen 8, 9 weisen eine solche Form auf und sind so zueinander ausgerichtet, dass die eine Klemmkraft auf die Oberfläche der Seitenkante der Leiterplatten 1, 2 bewirken können, aber nicht müssen. Eine solche Klemmung hat den Vorteil, dass Toleranzen und Vibrationen ausgeglichen bzw. aufgefangen werden. Zur dauerhaften Festlegung im Sinne einer Unbeweglichkeit an der Leiterplatte 1, 2 weisen die Distanzhalter 3 im Bereich 4, 5 Rastmittel auf, die mit Rastmitteln an der Leiterplatte 1, 2 korrespondieren. Diese Rastmittel sind bei dem Ausführungsbeispiel gemäß Figur 2, genauso wie bei dem Ausführungsbeispiel gemäß Figur 1, als Rasthaken 12, ausgebildet, die aus der oberen Lasche 10 ausgestanzt sind. Diese Rasthaken 12 sind so geformt und ausgerichtet, dass sie in eine korrespondierende Öffnung der Leiterplatte 1, 2 eingreifen, wenn diese stirnseitig an dem Rückenteil 6 zur Anlage gekommen ist oder kurz vorher. Alternativ oder ergänzend ist es denkbar, dass diese Rasthaken 12 auch in der unteren Lasche 8 vorhanden ist.

Während der Distanzhalter 3 gemäß der Figur 2 mit seinem Rückenteil 6 und den abstehenden Seitenteilen 7 symmetrisch aufgebaut ist und in etwa wannenförmig ausgestaltet ist, ist der Distanzhalter 3 gemäß Figur 1 asymmetrisch, da hier nur ein Seitenteil vom Rückenteil ausgeht und am Ende des Seitenteils nur jeweils nur eine untere Lasche vorhanden ist. So bietet es sich beispielsweise an, den Distanzhalter 3 gemäß Figur 1, der schmal gestaltet ist, dann einzusetzen, wenn längs einer Seitenkante der Leiterplatte 1, 2 mehrere Distanzhalter angebracht werden sollen oder deren Längserstreckung nicht so groß ist. Ist die Längserstreckung der Leiterplatten 1, 2 größer, können mehrere Distanzhalter 3 gemäß Figur 1 oder auch beispielsweise nur ein Distanzhalter 3 gemäß Figur 2 zum Einsatz kommen.

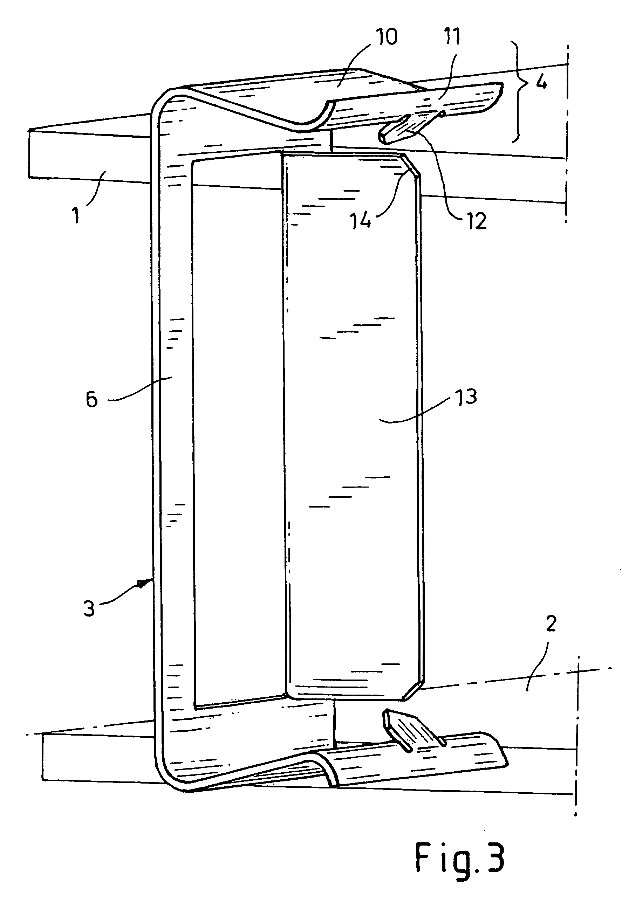

Figur 3 zeigt ein weiteres Ausführungsbeispiel des Distanzhalters 3, bei dem aus dem Rückenteil 6 ein Flügelsteg 13 ausgestanzt und abgewinkelt ist. Dieser Distanzhalter 3 weist also im Gegensatz zu den anderen Ausführungsbeispielen kein Seitenteil auf, welches sich ausgehend von dem Rückenteil etwa im rechten Winkel als Seitenteil erstreckt. Auch sind bei diesem Ausführungsbeispiel keine unteren Laschen vorhanden, da die obere und untere Stirnseite des Flügelsteges 13 diese Aufgabe übernimmt. Das heißt, dass sich die Leiterplatten 1, 2 an den oberen und unteren Stirnseiten des Flügelsteges 13, die sich in Richtung der oberen Laschen 10 erstrecken, abstützen können. Zwecks Montagevereinfachung sind auch hier Abwinklungen 14 an den Eckbereichen des Flügelsteges 13 vorhanden. Ebenso können die Stirnseiten des Flügelsteges 13 und die oberen Laschen 10 so zueinander ausgerichtet sein, dass eine Klemmung erfolgt oder unterbleibt. Auch hier sind wieder Rasthaken 12 aus den oberen Laschen 10 ausgestanzt und gebogen, wobei es selbstverständlich auch denkbar ist, alternativ oder ergänzende dazu entsprechende Rastmittel an dem Flügelsteg 13 vorzusehen.

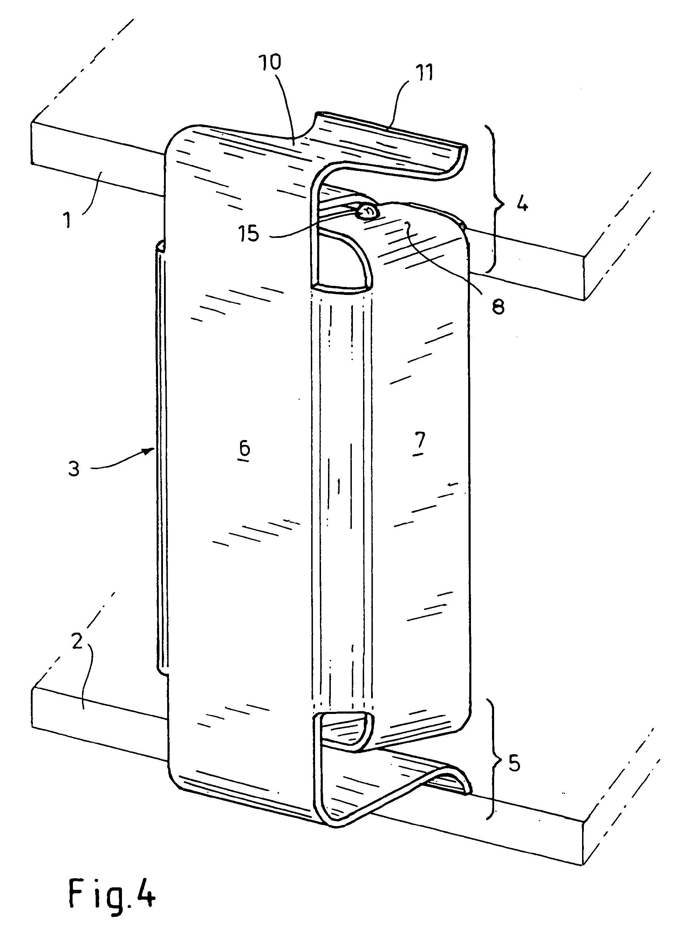

Figur 4 zeigt ein weiteres Ausführungsbeispiel des Distanzhalters 3, der so gestaltet ist, wie das Ausführungsbeispiel 2 oder auch so gestaltet sein kann, wie das Ausführungsbeispiel gemäß Figur 1 oder Figur 3. Hier sind die Rastmittel allerdings nicht als Rasthaken, sondern als Rastpilze 15 ausgestaltet, wobei der Durchmesser und die Höhe des Rastpilzes 15 der korrespondierenden Ausnehmung in der Leiterplatte 1, 2 angepasst ist.

Die vorstehend beschriebenen und in den Figuren 1 bis 4 gezeigten Distanzhalter 3 dokumentieren damit eine Vielzahl von verschiedenen konstruktiven Möglichkeiten, wie der Distanzhalter 3 selber und seine Mittel zur rastenden Befestigung an den Leiterplatten 1, 2 gestaltet sein kann. Daneben gibt es eine Vielzahl von Möglichkeiten, wie die Distanzhalter auf Grund anderer geometrischer Formen ebenfalls gestaltet sein können. So ist es nicht zwangsweise erforderlich, dass die Seitenteile in etwa im rechten Winkel von dem Rückenteil abstehen, sondern auch Winkel größer oder kleiner 90° denkbar sind. Außerdem muss-die Querschnittsform des Distanzhalters nicht zwangsweise quadratisch oder rechteckförmig sein, sondern kann auch andere geometrische Formen (z.B. runde oder elliptische Querschnittsformen) aufweisen. Nicht dargestellt aber vorhanden sein können weitere kraft- und/oder formschlüssig wirkende Mittel, die bewirken, dass der Distanzhalter 3 an dem Gehäuse, z.B. am Deckel, am Boden oder an der Seite, festgelegt wird, So können beispielsweise aus dem Rückenteil 6 des Distanzhalters 3 Rasthaken oder Rastpilze oder dergleichen ausgestanzt sein. Nachdem in entsprechender Anzahl die Distanzhalter 3 an den Seiten der Leiterplatten 1, 2 befestigt und diese damit zu einem "Sandwich" miteinander verbunden worden sind, kann dieses Paket in das Gehäuse, vorzugsweise in eine Gehäuseschale, eingesetzt werden, wobei am Rückenteil zumindest eines Teiles der Distanzhalter, vorzugsweise an allen Distanzhaltern (zwecks Gleichteilestrategie) Feder- oder Rastmittel angeordnet sind. Diese Feder- und/oder Rastmittel bewirken, dass die Distanzhalter an dem Gehäuse zwecks Toleranz- und/oder Spielausgleich festgelegt werden, um die Leiterplatten 1, 2 in einer definierten Lage innerhalb des Gehäuses festzulegen, um den Anforderungen des elektronischen Gerätes in einem Fahrzeug gerecht zu werden.

### Bezugszeichenliste

- 1.: Leiterplatte
- 2.: Leiterplatte
- 3.: Distanzhalter
- 4.: Klemmbereich
- 5.: Klemmbereich
- 6.: Rückenteil
- 7.: Seitenteil
- 8.: untere Lasche
- 9.: Abwinklung
- 10.: obere Lasche
- 11.: Abwinklung
- 12.: Rasthaken
- 13.: Flügelsteg
- 14.: Abwinklung
- 15.: Rastpilz

## Patentansprüche

1. Gehäuse eines elektronischen Gerätes, ausgebildet für den Einsatz in einem Fahrzeug, wobei in dem Gehäuse zumindest zwei Leiterplatten (1, 2) mit Bauteilen zur Realisierung der Funktion des Gerätes untergebracht sind, **dadurch gekennzeichnet, dass** die zumindest zwei Leiterplatten (1, 2) planparallel und beabstandet in dem Gehäuse angeordnet sind, wobei seitlich an einem Rand der Leiterplatten (1, 2) Distanzhalter (3) rastend an den Leiterplatten (1, 2) befestigt sind.

2. Gehäuse nach Anspruch 1, **dadurch gekennzeichnet, dass** der Distanzhalter (3) als Stanzbiegeteil ausgebildet ist.

3. Gehäuse nach Anspruch 1 oder 2, **dadurch gekennzeichnet, dass** der Distanzhalter (3) an seinen beiden Enden einen Befestigungsbereich, insbesondere einen Klemmbereich (4, 5), zur Aufnahme des seitlichen Randes der Leiterplatten (1, 2) aufweist.

4. Gehäuse nach Anspruch 3, **dadurch gekennzeichnet, dass** der Klemmbereich (4, 5) gebildet ist von zumindest einer unteren und zumindest einer oberen Lasche (8, 10), wobei die zumindest eine untere Lasche (8) aus einem Seitenteil (7) und die zumindest eine obere Lasche (10) aus einem Rückenteil (6) des Distanzhalters (3) geformt ist.

5. Gehäuse nach Anspruch 3, **dadurch gekennzeichnet, dass** der Klemmbereich (4, 5) gebildet ist von zumindest einer oberen Lasche (10) und einem aus dem Rückenteil (6) des Distanzhalters (3) geformten, senkrecht zu den Leiterplatten (1, 2) ausgerichteten Flügelsteg (13).

6. Gehäuse nach Anspruch 4 oder 5, **dadurch gekennzeichnet, dass** die Laschen (8, 10) bzw. der Flügelsteg (13) eine Abwinklung (9, 11, 14) aufweisen.

7. Gehäuse nach einem der vorhergehenden Ansprüche, **dadurch gekennzeichnet, dass** zumindest eine der Laschen (8, 10) Rastmittel aufweisen.

8. Gehäuse nach Anspruch 7, **dadurch gekennzeichnet, dass** die Rastmittel als Rasthaken (12), Rastpilz (15) oder Rastöffnung ausgebildet sind und mit korrespondierenden Rastmitteln an oder in der Leiterplatte (1, 2) zusammenwirken.

9. Gehäuse nach einem der vorhergehenden Ansprüche, **dadurch gekennzeichnet, dass** der Distanzhalter (3) zur festen oder federnden Befestigung an dem Gehäuse ausgebildet ist.

## Claims

1. Housing of an electronic appliance, designed for use in a vehicle, with at least two printed circuit boards (1, 2) with components to provide the function of the appliance being accommodated in the housing, **characterized in that** the at least two printed circuit boards (1, 2) are arranged plane-parallel and at a distance from one another in the housing, with spacers (3) being attached to the printed circuit boards (1, 2) by latching at the side of one edge of the printed circuit boards (1, 2).

2. Housing according to Claim 1, **characterized in that** the spacer (3) is a stamped and bent part.

3. Housing according to Claim 1 or 2, **characterized in that** the spacer (3) has an attachment area at both of its ends, in particular a clamping area (4, 5), for holding the side edge of the printed circuit boards (1, 2).

4. Housing according to Claim 3, **characterized in that** the clamping area (4, 5) is formed by at least one lower and at least one upper lug (8, 10), with the at least one lower lug (8) being formed from a side part (7) and the at least one upper lug (10) being formed from a rear part (6) of the spacer (3).

5. Housing according to Claim 3, **characterized in that** the clamping area (4, 5) is formed by at least one upper lug (10) and a vane web (13) which is formed from the rear part (6) of the spacer (3) and is aligned at right angles to the printed circuit boards (1, 2).

6. Housing according to Claim 4 or 5, **characterized in that** the lugs (8, 10) and the vane web (13) have an angle (9, 11, 14).

7. Housing according to one of the preceding claims, **characterized in that** at least one of the lugs (8, 10) has latching means.

8. Housing according to Claim 7, **characterized in that** the latching means are in the form of a latching hook (12), a latching mushroom head (15) or a latching opening, and interact with corresponding latching means on or in the printed circuit board (1, 2).

9. Housing according to one of the preceding claims, **characterized in that** the spacer (3) is designed for fixed or sprung attachment to the housing.

## Revendications

1. Boîtier pour un appareil électronique, prévu pour l'utilisation dans un véhicule, dans lequel au moins deux plaquettes de circuits imprimés (1, 2) avec des composants pour mettre en oeuvre la fonction de l'appareil sont montées dans le boîtier, **caractérisé en ce que** les au moins deux plaquettes de circuits imprimés (1, 2) sont plan-parallèles et espacées dans le boîtier, des éléments d'espacement (3) étant fixés par encliquetage sur les plaquettes de circuits imprimés (1, 2) latéralement au niveau d'un bord des plaquettes de circuits imprimés (1, 2).

2. Boîtier selon la revendication 1, **caractérisé en ce que** l'élément d'espacement (3) est réalisé sous forme de pièce pliée par estampage.

3. Boîtier selon la revendication 1 ou 2, **caractérisé en ce que** l'élément d'espacement (3) présente à ses deux extrémités une zone de fixation, notamment une zone de serrage (4, 5) pour recevoir le bord latéral des plaquettes de circuits imprimés (1, 2).

4. Boîtier selon la revendication 3, **caractérisé en ce que** la zone de serrage (4, 5) est formée par au moins une patte inférieure et au moins une patte supérieure (8, 10), l'au moins une patte inférieure (8) se composant d'une partie latérale (7) et l'au moins une patte supérieure (10) se composant d'une partie de dos (6) de l'élément d'espacement (3).

5. Boîtier selon la revendication 3, **caractérisé en ce que** la zone de serrage (4, 5) est formée par au moins une patte supérieure (10) et une aile (13) orientée perpendiculairement aux plaquettes de circuits imprimés (1, 2) et formée à partir de la partie de dos (6) de l'élément d'espacement (3).

6. Boîtier selon la revendication 4 ou 5, **caractérisé en ce que** les pattes (8, 10) ou l'aile (13) présentent un coudage (9, 11, 14).

7. Boîtier selon l'une quelconque des revendications précédentes, **caractérisé en ce qu'**au moins l'une des pattes (8, 10) présente des moyens d'encliquetage.

8. Boîtier selon la revendication 7, **caractérisé en ce que** les moyens d'encliquetage sont réalisés sous forme de crochet d'encliquetage (12), de champignon d'encliquetage (15) ou d'ouverture d'encliquetage et coopèrent avec des moyens d'encliquetage correspondants sur ou dans la plaquette de circuits imprimés (1, 2).

9. Boîtier selon l'une quelconque des revendications précédentes, **caractérisé en ce que** l'élément d'espacement (3) est réalisé pour la fixation rigide ou élastique sur le boîtier.
